# EUROPEAN PATENT APPLICATION

(11) **EP 4 797 897 A1**
(43) Date of publication of application: **26.08.2026**
(21) Application number: 25159281.2
(22) Date of filing: 21.02.2025
(51) Int. Cl.: H10B 10/00, H10D 62/10, H10D 84/01, H10D 89/10

(54) **INTEGRATED CIRCUIT AND A METHOD OF MANUFACTURING THEREOF**

(71) Applicant: Huawei Technologies Co., Ltd., Shenzhen, Guangdong 518129 (CN)
(72) Inventor: BHUWALKA, Krishna Kumar, 80992 Munich (DE)
(74) Representative: Körber, Martin Hans

(57) **Abstract**

In some examples, an integrated circuit comprises a logic region comprising multiple transistors each having a channel thickness and a channel width, and a memory region comprising multiple transistors each having a channel thickness and a channel width, wherein a channel thickness of each transistor in the logic region is smaller than a channel thickness of each transistor in the memory region, wherein a gate length of each transistor in the memory region is longer than the gate length of each transistor in the logic region, wherein each of the multiple transistors in the logic region comprises a first number of nanosheets, wherein each of the multiple transistors in the memory region comprises a second number of nanosheets, wherein the first number of nanosheets and the second number of nanosheets are the same.

## Description

### TECHNICAL FIELD

The present disclosure relates, in general, to semiconductor devices and integrated circuits. Aspects of the disclosure relate to nanosheet-based transistor architectures for logic and memory applications, particularly addressing variability and performance trade-offs in static random-access memory (SRAM) and core logic regions of an integrated circuit.

### BACKGROUND

Advancements in semiconductor technology have led to the development of nanosheet-based (NS) transistors, which provide enhanced electrostatic control and improved scalability compared to traditional FinFET devices. These transistors are widely employed in complementary metal-oxide-semiconductor (CMOS) logic applications, including central processing units (CPUs) and graphics processing units (GPUs), where high performance and power efficiency are critical.

In modem integrated circuits, SRAM is frequently used as on-chip cache memory due to its low-latency and high-speed characteristics. However, SRAM devices have distinct design requirements compared to core logic devices. While logic transistors are optimised for high-speed switching and computational efficiency, SRAM transistors prioritise low leakage and minimal variability to ensure stable and reliable memory operation. These differing requirements introduce challenges in the co-integration of logic and memory transistors within the same chip.

One conventional approach involves designing separate nanosheet transistors for SRAM and core logic regions, each with distinct channel thicknesses, widths, and work function materials. This method allows for device optimisation but introduces significant manufacturing complexities. In prior implementations, nanosheet transistors with different thicknesses require different stack configurations, resulting in a varying number of nanosheets across different regions. Consequently, achieving uniform channel geometry while maintaining electrical performance consistency has been challenging.

Furthermore, scaling down logic transistors for improved computational performance has exacerbated variability issues, particularly in SRAM devices. As nanosheet thickness decreases, threshold voltage (Vt) variability increases, leading to degraded memory reliability and performance. Prior approaches attempted to mitigate this issue by introducing different gate widths and thicknesses for n-type and p-type transistors, optimising performance for each device type. However, these methods often resulted in misalignment between SRAM and core logic transistors, leading to process complexity, loss of effective channel width (Weff), and increased fabrication costs.

Another drawback of previous designs is the requirement for additional epitaxial regrowth steps to accommodate different transistor dimensions in logic and memory regions. This process increases manufacturing variability and can introduce misalignment, further degrading device performance. Additionally, conventional SRAM and logic designs often fail to maintain consistent nanosheet stacking across different regions, leading to discrepancies in electrical characteristics and reduced scalability.

### SUMMARY

An objective of the present disclosure is to provide an integrated circuit architecture that enables improved short-channel control and reduced variability in nanosheet-based transistors, particularly in logic and memory regions.

The foregoing and other objectives are achieved by the features of the independent claims.

Further implementation forms are apparent from the dependent claims, the description and the Figures.

A first aspect of the present disclosure provides an integrated circuit comprising a logic region comprising multiple transistors each having a channel thickness and a gate length, and a memory region comprising multiple transistors each having a channel thickness and a gate length, wherein a channel thickness of each transistor in the logic region is smaller than a channel thickness of each transistor in the memory region, a gate length of each transistor in the memory region is longer than the gate length of each transistor in the logic region, wherein each of the multiple transistors in the logic region comprises a first number of nanosheets, wherein each of the multiple transistors in the memory region comprises a second number of nanosheets, wherein the first number of nanosheets and the second number of nanosheets are the same.

The nanosheets in each transistor in the logic region and the nanosheets in each transistor in the memory region may be centre-aligned relative to a vertical axis passing through the middle of the nanosheet stack for that transistor.

The channel thickness of each transistor in the logic region may be in a range of 2 nanometres to 5 nanometres, the gate length of each transistor in the logic region may be in a range of 5 nanometres to 25 nanometres, the channel thickness of each transistor in the memory region may be in a range of 3 nanometres to 6 nanometres, and the gate length of each transistor in the memory region may be in a range of 6 nanometres to 25 nanometres.

A difference between the gate length of each transistor in the memory region and the gate length of each transistor in the logic region may be equal to at least 1 nanometre.

The multiple transistors in the logic region and the multiple transistors in the memory region may comprise complementary metal-oxide-semiconductor (CMOS) transistors.

Both the logic region and the memory region may comprise n-type and p-type transistors, wherein the channel width of the n-type transistors in the logic region may be different from the channel width of the p-type transistors in the logic region, and the channel width of the n-type transistors in the memory region may be different from the channel width of the p-type transistors in the memory region.

A second aspect of the present disclosure provides a method of manufacturing an integrated circuit, the method comprising forming a logic region comprising multiple transistors, each transistor having a channel thickness and a gate length, and forming a memory region comprising multiple transistors, each transistor having a channel thickness and a gate length, wherein a channel thickness of each transistor in the logic region is smaller than a channel thickness of each transistor in the memory region, a gate length of each transistor in the memory region is longer than the gate length of each transistor in the logic region, wherein each of the multiple transistors in the logic region comprises a first number of nanosheets, and each of the multiple transistors in the memory region comprises a second number of nanosheets, wherein the first number of nanosheets and the second number of nanosheets are the same.

Forming the logic region and forming the memory region may comprise forming an epitaxial stack for both the logic region and the memory region, such that the stack comprises the first number of nanosheets for each transistor in the logic region and the second number of nanosheets for each transistor in the memory region, performing a recess step to define active areas for transistors in both the logic region and the memory region, and selectively removing a sacrificial layer from regions where gate stacks will be formed after forming a source terminal and/or a drain terminal.

The method may further comprise selectively over-etching the sacrificial layer, such that the nanosheets in the logic region and the memory region may be centre-aligned relative to a vertical axis passing through the middle of the nanosheet stack for each transistor.

The method may further comprise thinning down the channel in the logic region to achieve the channel thickness in a range of 2 nanometres to 5 nanometres for each transistor in the logic region.

The method may further comprise maintaining a thicker channel in the memory region achieve the channel thickness in a range of 3 nanometres to 6 nanometres for each transistor in the memory region.

A difference between the gate length of each transistor in the memory region and the gate length of each transistor in the logic region may be equal to at least 1 nanometre.

The method may further comprise depositing gate stacks and forming contact regions for both the transistors in the logic region and the memory region.

These and other aspects of the invention will be apparent from the embodiment(s) described below.

### BRIEF DESCRIPTION OF THE DRAWINGS

In order that the present invention may be more readily understood, embodiments of the invention will now be described, by way of example, with reference to the accompanying drawings, in which:
Figure 1 is a schematic representation of an integrated circuit according to an example,
Figure 2 is a flow chart of a method of manufacturing an integrated circuit according to an example; and
Figures 3a-3c are schematic representations of an integrated circuit at different stages of manufacturing according to an example.

### DETAILED DESCRIPTION

Example embodiments are described below in sufficient detail to enable those of ordinary skill in the art to embody and implement the systems and processes herein described. It is important to understand that embodiments can be provided in many alternate forms and should not be construed as limited to the examples set forth herein.

Accordingly, while embodiments can be modified in various ways and take on various alternative forms, specific embodiments thereof are shown in the drawings and described in detail below as examples. There is no intent to limit to the particular forms disclosed. On the contrary, all modifications, equivalents, and alternatives falling within the scope of the appended claims should be included. Elements of the example embodiments are consistently denoted by the same reference numerals throughout the drawings and detailed description where appropriate.

The terminology used herein to describe embodiments is not intended to limit the scope. The articles "a," "an," and "the" are singular in that they have a single referent, however the use of the singular form in the present document should not preclude the presence of more than one referent. In other words, elements referred to in the singular can number one or more, unless the context clearly indicates otherwise. It will be further understood that the terms "comprises," "comprising," "includes," and/or "including," when used herein, specify the presence of stated features, items, steps, operations, elements, and/or components, but do not preclude the presence or addition of one or more other features, items, steps, operations, elements, components, and/or groups thereof.

Unless otherwise defined, all terms (including technical and scientific terms) used herein are to be interpreted as is customary in the art. It will be further understood that terms in common usage should also be interpreted as is customary in the relevant art and not in an idealized or overly formal sense unless expressly so defined herein.

The present disclosure is described with reference to flow charts and/or block diagrams of the method, devices and systems according to examples of the present disclosure. Although the flow diagrams described above show a specific order of execution, the order of execution may differ from that which is depicted. Blocks described in relation to one flow chart may be combined with those of another flow chart. In some examples, some blocks of the flow diagrams may not be necessary and/or additional blocks may be added. It shall be understood that each flow and/or block in the flow charts and/or block diagrams, as well as combinations of the flows and/or diagrams in the flow charts and/or block diagrams can be realized by machine readable instructions.

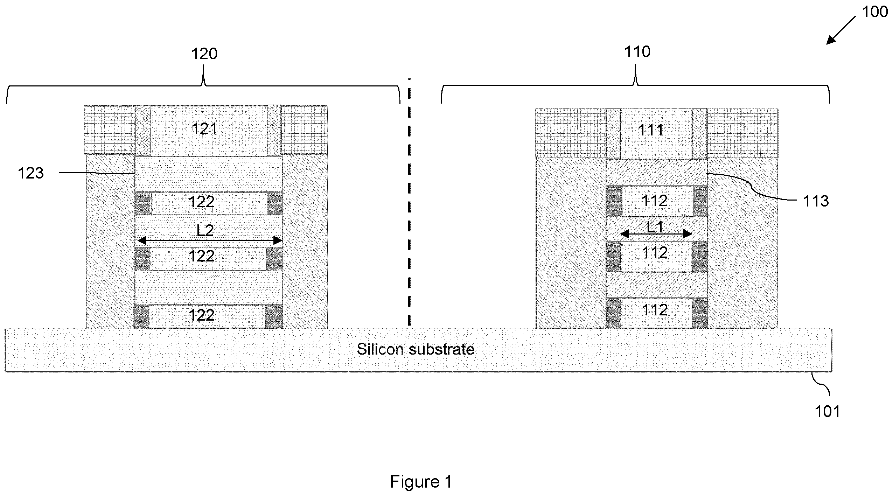

Figure 1 is a schematic representation of an integrated circuit according to an example. An integrated circuit 100 comprises a logic region 110, comprising multiple transistors, each having a channel thickness and a gate length. Here, the term "channel" refers to the region within a transistor through which charge carriers (electrons or holes) flow between the source and drain terminals when the transistor is in operation. Although only one transistor is shown in the logic region 110 in Figure 1, the skilled person would appreciate that the invention is not limited thereto and that any number of transistors may be present in the logic region 110.

The integrated circuit 100 also comprises a memory region 120, also comprising multiple transistors, each having a channel thickness and a gate length. The multiple transistors in the logic region 110 and the memory region 120 may comprise complementary metal-oxide-semiconductor (CMOS) transistors.

A channel thickness of each transistor in the logic region 110 is smaller than a channel thickness of each transistor in the memory region 120, and a gate length of each transistor in the memory region 120 is longer than the gate length of each transistor in the logic region 110.

The channel thickness of each transistor in the logic region 110 may be in a range of 2 nanometres to 5 nanometres. In contrast, the channel thickness of each transistor in the memory region 120 may be in a range of 3 nanometres to 6 nanometres. The gate length of each transistor in the logic region 110 may be in a range of 5 nanometres to 25 nanometres. In contrast, the gate length of each transistor in the memory region 120 may be within a range of 6 nanometres to 25 nanometres. Channel length of each transistor in the memory region 120 may be longer than the channel length of each transistor in the logic region 110.

Each of the multiple transistors in the logic region 110 comprises a first number of nanosheets, while each of the multiple transistors in the memory region 120 comprises a second number of nanosheets. The first number of nanosheets and the second number of nanosheets are the same, i.e., the number of nanosheets in each of the multiple transistors in the logic region 110 is the same as the number of nanosheets in each of the multiple transistors in the memory region 120.

In the example shown in Figure 1, a transistor in the logic region 110 may comprise an outer gate 111 and multiple inner gates 112. The transistor in the logic region 110 may also comprise multiple layers of silicon-germanium (SiGe) or germanium alone (Ge), serving as sacrificial layers that are selectively removed during the fabrication process to define and isolate the silicon nanosheets, which form the active channel regions of the transistors. Similarly, each transistor in the memory region 120 may comprise an outer gate 121 and multiple inner gates122. The transistor in the memory region 120 may also comprise multiple layers of silicon-germanium (SiGe) or germanium alone (Ge), serving as sacrificial materials for structural definition.

A length of an inner gate 112 of a transistor in the logic region 110 may be denoted as L1. For example, a length of an inner gate 122 of a transistor in the memory region 120 may be denoted as L2. As visible from the figure, a gate length of each transistor in the memory region 120 may be longer than a gate length of each transistor in the logic region 110. Advantageously, a longer gate length in memory transistors helps reduce leakage currents and improves data retention stability, while shorter gate lengths in logic transistors enhance switching speed and overall performance. A difference between the gate length of each transistor in the memory region 120 and the gate length of each transistor in the logic region may be different by at least one nanometre.

Both the logic region 110 and the memory region 120 may comprise n-type and p-type transistors. The channel width can vary independently and may be larger or smaller for different transistors, including n-type and p-type transistors in both the logic and memory regions. The gate length of the n-type transistors in the logic region 110 may be from the same as the gate length of the p-type transistors in the same region, i.e., logic region 110. Similarly, the gate length of the n-type transistors in the memory region 120 may be the same as the gate length of the p-type transistors in the memory region 120. The channel thickness of each transistor in the memory region 120 may be larger than the channel thickness of each transistor in the logic region 110. The gate length of each transistor in the memory region 120 may be longer than the gate length of each transistor in the logic region 110.

The logic region 110 and the memory region 120 may be grown on a silicon substrate 101, as will be described later in relation to the process of manufacturing the integrated circuit 100. The nanosheets in each transistor in the logic region 110 and the nanosheets in each transistor in the memory region 120 may be centrally aligned relative to a vertical axis passing through the middle of the nanosheet stack for that transistor. This central alignment may help in ensuring uniform electrical characteristics across the width of the channel, reducing variability and improving device reliability.

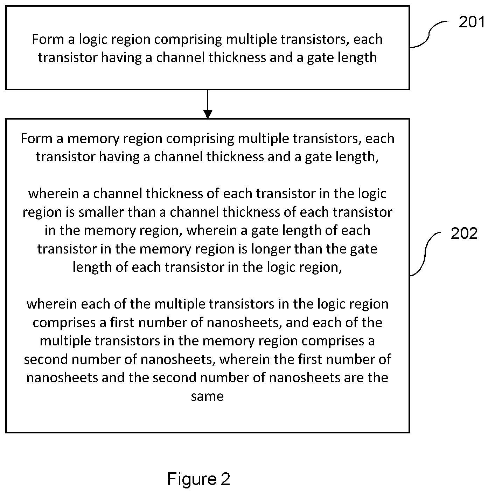

Figure 2 is a flow chart of a method of manufacturing an integrated circuit according to an example. The method comprises, in block 201, forming a logic region comprising multiple transistors, each transistor having a channel thickness and a gate length. The logic region formed in block 201 may correspond to the logic region 110 described above in relation to Figure 1.

In block 202, the method comprises forming a memory region comprising multiple transistors, each transistor having a channel thickness and a gate length. The memory region formed in block 202 may correspond to the memory region 120 described above in relation to Figure 1. A channel thickness of each transistor in the logic region is smaller than a channel thickness of each transistor in the memory region, wherein a gate length of each transistor in the memory region is longer than the gate length of each transistor in the logic region. Each of the multiple transistors in the logic region comprises a first number of nanosheets, and each of the multiple transistors in the memory region comprises a second number of nanosheets, wherein the first number of nanosheets and the second number of nanosheets are the same.

Forming the logic region (block 201) and forming the memory region (block 202) may comprise forming an epitaxial stack for both the logic region and the memory region, such that the stack comprises the first number of nanosheets for each transistor in the logic region and the second number of nanosheets for each transistor in the memory region. The epitaxial stack may consist of alternating layers of silicon and silicon-germanium. After the epitaxial stack has been formed, a recess step may be performed to define active areas for transistors in both the logic region and the memory region. This recess step may, for example, comprise etching specific regions of the stack to create trenches.

Following this, a sacrificial layer may be selectively removed from regions where gate stacks will be formed after forming a source terminal and/or a drain terminal. The sacrificial layer may be selectively over-etched, such that the nanosheets in the logic region and the memory region are centrally aligned relative to a vertical axis passing through the middle of the nanosheet stack for each transistor.

To ensure that the channels in the memory region and the channels in the logic region have the desired dimensions, during the manufacturing process, the channels in the logic region may be thinned down to achieve the channel thickness in a range of 2 nanometres to 5 nanometres for each transistor in the logic region. Similarly, thicker channels may be maintained in the memory region, so as to achieve the channel thickness in a range of 3 nanometres to 6 nanometres for each transistor in the memory region.

As discussed above in relation to Figure 1, a difference between the gate length of each transistor in the memory region and the gate length of each transistor in the logic region may be equal to at least 1 nanometre.

The method may further comprise depositing gate stacks and forming contact regions for both the transistors in the logic region and the transistors in the memory region.

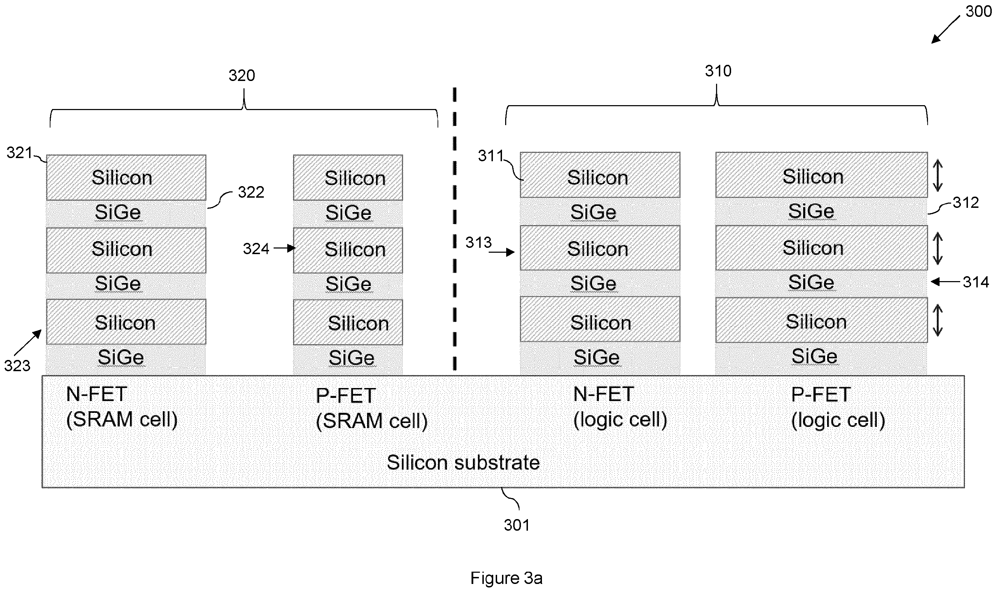

Figures 3a-3c are schematic representations of an integrated circuit at different stages of manufacturing according to an example. In particular, Figure 3a illustrates an intermediate structure of the integrated circuit (IC) device 300 during the manufacturing process. The IC device 300 may comprise a logic region 310 and a memory region 320, both formed on a silicon substrate 301. The logic region 310 and the memory region 320 may correspond to the logic region 110 and the memory region 310. The same elements between Figures 1 and 3a-3c are denoted using similar reference numerals and function likewise.

In both regions, an epitaxial (epi) stack comprising alternating layers of silicon 311, 321 and/or silicon-germanium (SiGe) 312, 322 may be formed. The Si/SiGe epi-stack may be the same for transistors in both the logic region 310 and the memory region 320. The memory region 320 may include N-type field-effect transistors (N-FETs) 323 and P-type field-effect transistors (P-FETs) 324, commonly used in SRAM cells. The logic region 310 may include N-FETs 313 and P-FETs 314 for logic cells.

The transistors in the logic region 310 and the memory region 320 may differ in channel dimensions. Specifically, the channel thickness of the transistors in the memory region 320 may be greater than that of the transistors in the logic region 310 to improve device variability. Additionally, the length of the gate may vary between N-FETs and P-FETs within each region.

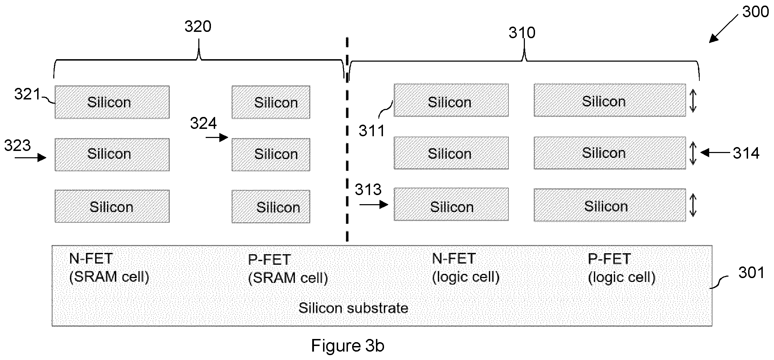

Figure 3b shows the structure after a selective removal process where the SiGe sacrificial layers 312, 322 may be etched away from regions where gate stacks will be formed. This removal step may expose silicon nanosheets 315, 325, which serve as the active channel materials for the transistors.

Following the removal of the SiGe layers, a thinning process may be applied to the silicon channels in the logic region 310 to achieve the desired thinner channel thickness for logic cell devices. The width of the silicon nanosheets 315, 325 may still vary across different transistors, as shown by the double-headed arrows indicating variable dimensions.

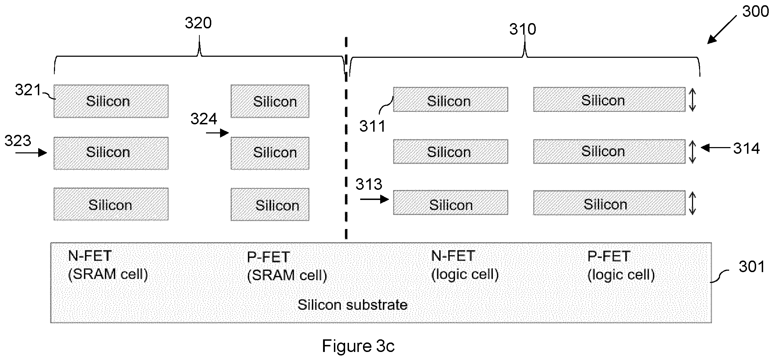

Figure 3c illustrates the structure after further thinning of the silicon nanosheets 315 in the logic region 310. Throughout these stages, the device width may vary between N-FETs and P-FETs within both the logic region 310 and the memory region 320, as well as between the logic and memory regions.

The preceding description has been provided to enable others skilled in the art to best utilize various aspects of the exemplary embodiments disclosed herein. This exemplary description is not intended to be exhaustive or to be limited to any precise form disclosed. Many modifications and variations are possible without departing from the spirit and scope of the instant disclosure. The embodiments disclosed herein should be considered in all respects illustrative and not restrictive. Reference should be made to the appended claims and their equivalents in determining the scope of the instant disclosure.

## Claims

1. An integrated circuit (100), comprising:
a logic region (110) comprising multiple transistors each having a channel thickness and a gate length; and
a memory region (120) comprising multiple transistors each having a channel thickness and a gate length,
wherein a channel thickness of each transistor in the logic region (110) is smaller than a channel thickness of each transistor in the memory region (120), a gate length of each transistor in the memory region (120) is longer than the gate length of each transistor in the logic region (110),
wherein each of the multiple transistors in the logic region (110) comprises a first number of nanosheets, wherein each of the multiple transistors in the memory region (120) comprises a second number of nanosheets, wherein the first number of nanosheets and the second number of nanosheets are the same.

2. The integrated circuit (100) of claim 1, wherein the nanosheets in each transistor in the logic region (110) and the nanosheets in each transistor in the memory region (120) are centre-aligned relative to a vertical axis passing through the middle of the nanosheet stack for that transistor.

3. The integrated circuit (100) of claim 1 or 2, wherein:
the channel thickness of each transistor in the logic region (110) is in a range of 2 nanometres to 5 nanometres,
the gate length of each transistor of the multiple transistors in the logic region (110) is in a range of 5 nanometres to 25 nanometres,
the channel thickness of each transistor in the memory region (120) is in a range of 3 nanometres to 6 nanometres, and
the gate length of each transistor of the memory region (120) is in a range of 6 nanometres to 25 nanometres.

4. The integrated circuit (100) of claim 1, 2 or 3, wherein a difference between the gate length of each transistor in the memory region (120) and the gate length of each transistor in the logic region (110) is equal to at least 1 nanometre.

5. The integrated circuit (100) of any one of claims 1 to 4, wherein the multiple transistors in the logic region (110) and the multiple transistors in the memory region (120) comprise complementary metal-oxide-semiconductor, CMOS, transistors.

6. The integrated circuit (100) of any one of claims 1 to 5, wherein:
both the logic region (110) and the memory region (120) comprise n-type and p-type transistors, and
the channel width of the n-type transistors in the logic region (110) is different from the channel width of the p-type transistors in the logic region (110),
and the channel width of the n-type transistors in the memory region (120) is different from the channel width of the p-type transistors in the memory region (120).

7. A method of manufacturing an integrated circuit, the method comprising:
forming a logic region comprising multiple transistors, each transistor having a channel thickness and a gate length (201); and
forming a memory region comprising multiple transistors, each transistor having a channel thickness and a gate length (202),
wherein a channel thickness of each transistor in the logic region is smaller than a channel thickness of each transistor in the memory region, wherein a gate length of each transistor in the memory region is longer than the gate length of each transistor in the logic region;
wherein each of the multiple transistors in the logic region comprises a first number of nanosheets, and each of the multiple transistors in the memory region comprises a second number of nanosheets, wherein the first number of nanosheets and the second number of nanosheets are the same.

8. The method of claim 7, wherein forming the logic region (201) and forming the memory region (202) comprises:
forming an epitaxial stack for both the logic region and the memory region, such that the stack comprises the first number of nanosheets for each transistor in the logic region and the second number of nanosheets for each transistor in the memory region;
performing a recess step to define active areas for transistors in both the logic region and the memory region; and
selectively removing a sacrificial layer from regions where gate stacks will be formed after forming a source terminal and/or a drain terminal.

9. The method of claim 8, further comprising: selectively over-etching the sacrificial layer, such that the nanosheets in the logic region and the memory region are centre-aligned relative to a vertical axis passing through the middle of the nanosheet stack for each transistor.

10. The method of claim 7, 8 or 9, further comprising thinning down the channel in the logic region to achieve the channel thickness in a range of 2 nanometres to 5 nanometres for each transistor in the logic region.

11. The method of any one of claims 7 to 10, further comprising maintaining a thicker channel in the memory region to achieve the channel thickness in a range of 3 nanometres to 6 nanometres for each transistor in the memory region.

12. The method of claim 11, wherein a difference between the gate length of each transistor in the memory region and the gate length of each transistor in the logic region is equal to at least 1 nanometre.

13. The method of any one of claims 8 to 12, further comprising depositing gate stacks and forming contact regions for both the transistors in the logic region and the memory region.
